**Europäisches Patentamt**

**European Patent Office**

**Office européen des brevets**

(11) Numéro de publication : **0 388 278 B1**

# FASCICULE DE BREVET EUROPEEN

(45) Date de publication du fascicule du brevet :
**27.12.95 Bulletin 95/52**

(51) Int. Cl.$^6$ : **H01L 21/48**

(21) Numéro de dépôt : **90400657.4**

(22) Date de dépôt : **13.03.90**

(54) **Procédé d'élaboration de moyens de connexions électriques, en particulier de substrats d'interconnexion pour circuits hybrides**

(30) Priorité : **16.03.89 FR 8903492**

(43) Date de publication de la demande :
**19.09.90 Bulletin 90/38**

(45) Mention de la délivrance du brevet :
**27.12.95 Bulletin 95/52**

(84) Etats contractants désignés :
**AT BE CH DE DK ES FR GB GR IT LI LU NL SE**

(56) Documents cités :
**EP-A- 0 135 174**
**EP-A- 0 286 690**
**IEEE TRANSACTIONS ON COMPONENTS, HYBRIDS, AND MANUFACTURING TECHNO-LOGY, vol.CHMT-8, no. 2, juin 1985, pages 253-258, IEEE, New York, US; N. IWASE et al.:"Thick film and direct bond copper forming technologies for aliminum nitridesubstrate"**
**29TH ELECTRONIC COMPONENTS CONFE-RENCE, Cherry Hill, NJ, 14-16 mai 1979, pages1-10, IEEE, New York, US; J.D. MIT-CHELL et al.: "Processing techniques forfabri-cating thick film copper/dielectric multilayer structures"**

(56) Documents cités :
**PROCEEDINGS OF THE ELECTRONIC COMPONENTS CONFERENCE, Seatle, 1986, pages 471-480, IEEE, New York, US; R.J. BACHER et al.: "Firing process-related failu-remechanisms in thick film copper multi-layers"**

(73) Titulaire : **L'AIR LIQUIDE, SOCIETE ANONYME POUR L'ETUDE ET L'EXPLOITATION DES PROCEDES GEORGES CLAUDE**
**75, Quai d'Orsay**
**F-75321 Paris Cédex 07 (FR)**

(72) Inventeur : **Mellul, Sylvie**
**45, rue E. Derrien**
**F-94400 Vitry-sur-Seine (FR)**
Inventeur : **Rotman, Frédéric, Teisan K.K.**
**9-1 Chinonome 1-chome Koto-ku**
**Tokyo 135 (JP)**
Inventeur : **Navarro, Dominique**
**34, Palais des Amandiers,**
**Villenave d'Ornon**
**F-33140 Pont de la Maye (FR)**

(74) Mandataire : **Le Moenner, Gabriel et al**
**L'AIR LIQUIDE, Société Anonyme**
**pour l'étude et l'exploitation des procédés Georges Claude**
**75, Quai d'Orsay**
**F-75321 Paris Cédex 07 (FR)**

EP 0 388 278 B1

## Description

La présente invention concerne un procédé d'élaboration de moyens de connexions électriques, en particulier de substrats d'interconnexion pour circuits hybrides, selon lequel on procède après dépôt d'une couche d'encre crue sur un support à haute dissipation thermique du type nitrure d'aluminium, à un séchage préliminaire de cette encre à une température de l'ordre de 100°C à 150°C, puis à une cuisson comprenant :

a) une montée en température incorporant une phase d'élimination des résines polymères,

b) un palier de frittage à une température de l'ordre de 600°C à 1000°C, et

c) un refroidissement temporisé.

La technologie "couche épaisse" est très largement employée en microélectronique pour la fabrication des substrats d'interconnexion des circuits hybrides. Ces substrats servent de supports et d'éléments d'interconnexion aux différents composants électroniques constituant le circuit, et à cet effet, ils sont essentiellement formés d'un support mécanique jouant également le rôle de dissipateur thermique, sur lequel sont rapportés des couches conductrices, isolantes et/ou résistives, qui réalisent à partir de motifs variés, l'ensemble des interconnexions. Le substrat est généralement une céramique, et le plus souvent de l'alumine avec un degré de pureté de 96 %.

Les couches épaisses sont elles mêmes réalisées à partir d'encres ou pâtes, qui sont essentiellement constituées d'une phase fonctionnelle, d'un liant inorganique, et d'un véhicule organique (solvants et résines polymères qui assurent à la pâte une bonne rhéologie).

La phase fonctionnelle assure les propriétés électriques de la couche au regard de la conductibilité, de la résistivité ou de l'isolation. Elle se présente sous forme de poudres qui sont métalliques pour les couches conductrices, à base de verres ou de céramiques pour les couches isolantes. Le liant inorganique a pour rôle d'assurer une bonne adhérence entre la couche et le support.

En pratique, le dépôt d'une couche d'encre crue sur le substrat s'effectue par sérigraphie selon un motif préalablement réalisé sur un écran qui est un tamis, et le dépôt est obtenu par passage de l'encre au travers des mailles du tamis ; l'opération de séchage vise à éliminer les solvants, tandis que la cuisson de l'ensemble à haute température réalise, après élimination des résines polymères, par frittage et/ou fusion des constituants, un film d'épaisseur comprise entre environ 5 microns et environ 50 microns, qui adhère à la surface du support.

La cuisson des couches d'encre après séchage représente une opération complexe de traitement thermique, au cours de laquelle le rôle de l'atmosphère est primordial. En particulier, l'atmosphère a pour but de constituer un environnement adéquat à un déroulement aussi correct que possible des opérations de frittage et d'adhérence de la couche sur le support.

Dans le cas des encres conductrices à base de métaux nobles tels que le platine, l'or, le palladium ou l'argent, ainsi que pour les encres isolantes et résistives compatibles, la cuisson est réalisée sous air. L'emploi d'une atmosphère oxydante telle que l'air est tout à fait approprié pour l'opération d'élimination des résines polymères restant dans la couche après séchage. L'oxygène présent dans l'atmosphère facilite cette élimination des résines par oxydation des composés organiques qui se vaporisent et se pyrolisent avec la montée en température.

Au contraire, dans le cas des encres conductrices à base d'un métal non noble tel que le cuivre ou autres matériaux dits compatibles, la cuisson nécessite une atmosphère inerte obtenue par l'emploi de gaz neutres tels l'azote, l'argon, l'hélium, le cas échéant une combinaison de ces gaz, afin d'éviter l'oxydation du métal.

Pour ces encres conductrices à base de cuivre, on recommande d'effectuer la cuisson sous azote, avec moins de 10 ppm d'oxygène présent dans l'atmosphère de la totalité du four. On peut citer à ce propos, à titre d'exemple, les notices d'emploi des encres au cuivre de Du Pont de Nemours, qui recommandent d'effectuer la cuisson des pâtes conductrices au cuivre dans une atmosphère d'azote contenant entre 5 et 10 ppm d'oxygène.

Dans une telle atmosphère, bien qu'elle contienne quelques p.p.m. d'oxygène, l'élimination des résines polymères est souvent incomplète, surtout quand de grands volumes de pâte sont traités ou encore dans le cas de la réalisation de multicouches qui enserrent des surfaces importantes de diélectrique. Il en résulte un certain nombre de détériorations des couches, notamment une diminution de leur adhérence sur le substrat. Les mécanismes d'apparition de ces détériorations ont été étudiés dans le cas du report d'encres au cuivre sur alumine, et sont en particulier décrits par R.J. Bacher et V.P. Siuta, dans un article intitulé "Firing Process-related Failure Mechanisms in Thick-Film Copper Multilayers" paru dans "Proc. of the Electronic Components Conference, IEEE", 1986 p 471-480.

Une solution proposée concerne le dopage préférentiel de l'atmosphère inerte du four par de l'oxygène, au niveau de la zone d'élimination des résines polymères, sans modifier les teneurs en oxygène des zones de frittage et de refroidissement. Les auteurs ont montré que la teneur en oxygène, même dans la zone d'élimination des résines polymères, doit rester limitée, en tout cas inférieure à 100 ppm, afin d'obtenir des résultats satisfaisants. A titre d'exemple, F. Franconville et M. Auray, dans un article intitulé "Copper displaces gold in production of multilayer substrates for computer application" paru dans "Proc of the Third European Hybrid Microelectronics Conference", 1981 p 174-187, ont proposé des conditions de cuisson de multicouches au cuivre sur alumine, en recommandant pour la cuisson des encres diélectriques compatibles cuivre la présence de 150 à 300 ppm d'oxygène dans la zone d'élimination des résines polymères, en notant toutefois que la cuisson des couches conductrices au cuivre doit s'effectuer sous azote contenant moins de 20 ppm d'oxygène dans toutes les phases de la cuisson.

Ces recommandations impliquent donc la mise en oeuvre de deux atmosphères différentes, l'une pour la cuisson des couches conductrices au cuivre, l'autre pour la cuisson des couches diélectriques compatibles cuivre.

En outre, dans l'article de R.J. Bacher et V.P. Siuta, cité précédemment, les auteurs ont également étudié les effets du dopage en oxygène de l'azote au niveau de la zone d'élimination des résines polymères sur les propriétés de circuits multicouches cuivre obtenus dans de telles conditions et sont parvenus à la conclusion que pour une teneur en oxygène aussi élevée que 100 ppm, l'herméticité des couches diélectriques est largement améliorée. Par contre, pour ce qui est des couches conductrices au cuivre, ces mêmes auteurs notent, pour des teneurs en oxygène de 100 ppm et pour des teneurs plus élevées, une nette dégradation de la soudabilité des couches cuivre. Ils annoncent des conditions correctes de soudabilité pour 30 ppm d'oxygène dans la zone d'élimination des liants polymères.

Enfin, E.A. Webb, dans un article intitulé "Effects of Copper Thick-Film Processing on Adhesion and Bondability" paru dans "Proc. of the 6th European Microelectronics Conference, ISHM", 1987 Bournemouth England p 128-135, a étudié l'influence des conditions d'atmosphère appliquées durant la cuisson de couches épaisses conductrices au cuivre sur l'adhésion et la soudabilité des circuits obtenus. Cet auteur constate une amélioration des propriétés d'adhésion pour des teneurs en oxygène dans la zone d'élimination des résines polymères allant de 7 à 15 ppm, alors qu'au delà de 15 ppm d'oxygène, l'auteur note une nette dégradation de la soudabilité des couches cuivre.

L'évolution de l'électronique vers l'utilisation de circuits de puissance et/ou l'élaboration de fonctions complexes nécessitant une implantation très dense des composants conduit à une dissipation de quantités de chaleur nettement plus importantes au niveau du substrat.

Cette évolution a entraîné la recherche de nouveaux matériaux électriquement isolants possédant une conductivité thermique plus élevée que celle de l'alumine. Les propriétés de l'oxyde de berylium (BeO) en font un candidat possible, mais sa toxicité, lorsqu'il se présente sous forme de poudre, a réduit son utilisation en pratique. Par contre, le nitrure d'aluminium (AlN) possède des propriétés de conduction électrique et thermique comparables, mais peut être manipulé et usiné sans danger.

Dans ce contexte, le système Cuivre/Nitrure d'aluminium représente finalement une solution toute à fait avantageuse pour la haute intégration des composants ainsi que pour la microélectronique de puissance, dans la mesure où il conjugue les propriétés exceptionelles du cuivre (haute conductivité électrique, excellente soudabilité à l'étain, plomb ...) et la conductivité thermique élevée du nitrure d'aluminium.

On a rappelé plus haut la difficulté d'obtention de couches épaisses cuivre de qualité sur alumine. La fabrication de couches épaisses cuivre sur nitrure d'aluminium présente des difficultés supplémentaires du fait du caractère non oxyde de cette céramique, qui semble être la cause d'une faible mouillabilité du nitrure d'aluminium par les métaux. Dans une lettre technique ("Material Matters", Vol VII, n° 3, Electro-Science Laboratories à présenté une étude comparative de l'adhésion initiale et après vieillissement obtenue dans le cas de couches épaisses cuivre réalisées sur différentes sources d'alumine et de nitrure d'aluminium. L'adhésion était suivie par pelage de plots de cuivre de $4mm^2$. Leurs résultats montrent que pour tous les substrats testés, les adhésions initiales et après vieillissement mesurées dans le cas d'un substrat de nitrure d'aluminium sont environ 50% plus faibles que les valeurs correspondantes obtenues pour un substrat d'alumine.

Le document paru dans "Proc. of IEEE Transactions on Components, Hybrids and Manufacturing Technology", Vol 8, N° 2, Juin 1985, page 253-258, rapporte quant à lui les résultats d'essais de métallisation de substrats d'ALN avec des encres conductrices au cuivre, l'atmosphère mise en place pour la cuisson étant de l'azote contenant moins de 10ppm d'oxygène.

Ces résultats ont montré des caractéristiques d'adhésion n'atteignant que $1,4 kg/mm^2$ dans le cas d'une seule des encres testées.

La présente invention a pour objectif de proposer une atmosphère d'élaboration de couches épaisses sur support à haute dissipation thermique de type nitrure d'aluminium, qui dans le cas d'encres ou pâtes à base de métaux non nobles tels que le cuivre, ou autres matériaux compatibles, assure une bonne adhérence des couches, une qualité excellente et une reproductibilité des propriétés électriques, mécaniques et thermiques de l'élément électronique, conditions indispensables à la réalisation et au bon fonctionnement de circuits électroniques mettant en oeuvre une implantation très dense de composants et/ou utilisant des circuits de puissance.

Selon l'invention, l'atmosphère de la phase d'élimination des résines polymères présente une teneur en oxygène comprise entre 100 ppm et 5000 ppm, alors que les teneurs en oxygène de l'atmosphère de frittage à haute température et de l'atmosphère de refroidissement doivent être inférieures à environ 10 ppm, et de préférence l'atmosphère de la phase d'élimination des résines polymères présente une teneur en oxygène comprise entre 250 ppm et 3000 ppm.

C'est donc le mérite de la présente invention d'avoir découvert, en contradiction apparente avec les travaux cités en référence plus haut, que lors de la cuisson de couches épaisses à base d'un métal non noble tel que le cuivre, sur support de nitrure d'aluminium, la présence d'oxygène dans l'atmosphère inerte d'un four, au niveau de la phase d'élimination des résines polymères améliore les caractéristiques physiques des couches, en particulier l'adhésion des couches sur le support, jusqu'à des valeurs comparables aux performances atteintes dans le cas du report de couches épaisses cuivre sur substrat d'alumine. Les performances correspondantes en résistivité sont bonnes malgré les teneurs en oxygène élevées utilisées.

Selon une forme de mise en oeuvre, on assure, préalablement à ladite élaboration une préoxydation du support de nitrure d'aluminium sous atmosphère oxydante, par exemple sous air ou sous un mélange d'azote, d'hydrogène et de vapeur d'eau, à une température comprise entre 1200 et 1500°C, pendant un temps de traitement de l'ordre d'une heure, ce qui améliore l'adhésion des couches sur le support. La cuisson des couches épaisses cuivre sur ces supports de nitrure d'aluminium préoxydés est alors effectuée dans une atmosphère inerte comportant, au niveau de la zone d'élimination des résines polymères, une teneur en oxygène inférieure à 250 ppm.

L'invention est maintenant détaillée en référence aux exemples ci-dessous :

On a utilisé des encres commerciales à base de cuivre que l'on a cuites sous différentes atmosphères à base d'azote après avoir été sérigraphiées et séchées en procédant de la façon qui est habituellement employée dans l'industrie.

Le motif de tests choisi comprend, entre autres, une lyre pour évaluer la résistivité, et des plots de taille différente pour évaluer l'adhérence. Les plots sont des carrés de 1,5 ou 2 mm de côté. Ce motif a été sérigraphié sur des substrats carrés en nitrure d'aluminium de 50,8 mm de côté. Le degré de pureté des substrats de nitrure d'aluminium utilisés est supérieur à 98 %.

Les cuissons sous atmosphères ont été réalisées dans un four à passage industriel classique du genre tapis transporteur. Le cycle complet de cuisson qui a été choisi dure 55 minutes avec un palier de frittage à 900°C (plus ou moins 2°C) pendant environ 10 minutes.

Après cuisson, un ensemble de tests électriques et mécaniques ont été réalisés, comprenant des mesures d'adhérence, de résistivité, de soudabilité et d'aptitude au cablage.

Pour l'adhérence qui est un paramètre particulièrement critique dans le cas des couches épaisses cuivre, on a opéré de la façon suivante : des crochets en cuivre ont été soudés à l'étain-plomb-argent (62-36-2) à 215°C sur des plots en cuivre, puis ces crochets ont subi des tests de traction et les forces de rupture ont été mesurées afin d'évaluer le pouvoir d'adhérence.

Le vieillissement a consisté à placer sous étuve à 150° C pendant 200 h, des crochets soudés sur des plots avant de leur faire subir des tests de traction, comme décrit précédemment.

Le test n° 1 a consisté en une cuisson sous atmosphère d'azote dit industriel, sans addition de dopants gazeux, dont la teneur en oxygène est de 4 ppm et la teneur en vapeur d'eau de 12 ppm.

Le test n° 2 a consisté en une cuisson sous atmosphère d'azote avec addition d'oxygène dans la zone d'élimination des résines polymères avec une teneur en oxygène de 500 ppm, la teneur en vapeur d'eau restant à 12 ppm.

Le test n° 3 a consisté en une cuisson sous atmosphère d'azote avec addition d'oxygène dans la zone d'élimination des résines polymères, avec une teneur en oxygène de 4000 ppm, la teneur en vapeur d'eau restant à 12 ppm.

Résultats comparatifs :

|  | Test n° 1 | Test n° 2 | Test n° 3 |
|---|---|---|---|
| Résistivité de la couche (milliohms/carré/18μm) | 1.60 ± 0.05 | 1.40 ± 0.05 | 2.00 ± 0.05 |
| Adhérence initiale (N/mm²) | nulle | 14 ± 2.5 | 30 ± 4.2 |
| Adhérence après vieillissement (N/mm²) | nulle | 6.2 ± 1.7 | 18.7 ± 1.7 |
| Aptitude au microcablage (en mN, cablage thermo-sonique de fil d'or de 30 μm de diamètre) | nulle | 94 ± 24 | 100 ± 21 |

Les couches épaisses cuivre obtenues dans le cadre du test n° 1 étaient très largement décollées du substrat, d'où une importante dégradation des propriétés électrique et mécaniques des couches, et une quasi-impossibilité d'effectuer les mesures.

Les résultats présentés montrent bien que l'addition d'oxygène exclusivement dans la zone d'élimination des résines polymères du four donne des caractéristiques physiques améliorées en ce qui concerne les couches épaisses cuivre sur substrat de nitrure d'aluminium en particulier pour l'adhésion initiale et après vieillissement.

## Revendications

1.  Procédé d'élaboration de moyens de connexions électriques, en particulier de substrats d'interconnexion pour circuits hybrides, selon lequel on procède après dépôt d'une couche d'encre crue à base de métaux non nobles sur un support à haute dissipation thermique du type nitrure d'aluminium, à un séchage préliminaire de cette encre à une température comprise entre 100°C et 150°C, puis à une cuisson comprenant :
    a) une montée en température incorporant une phase d'élimination des résines polymères contenues dans l'encre crue,
    b) un palier de frittage à une température comprise entre 600°C et 1000°C, et
    c) un refroidissement temporisé,
    l'atmosphère de la phase d'élimination des résines polymères présentant une teneur en oxygène pouvant aller à plusieurs centaines de ppm, alors que les teneurs en oxygène de l'atmosphère de frittage à la température comprise entre 600°C et 1000°C et de l'atmosphère du refroidissement restent inférieures à 10 ppm,
    caractérisé en ce que l'atmosphère de la phase d'élimination des résines polymères présente une teneur en oxygène comprise entre 100 ppm et 5.000 ppm.

2.  Procédé d'élaboration selon la revendication 1, caractérisé en ce que l'atmosphère de la phase d'élimination des résines polymères présente une teneur en oxygène comprise entre 250 ppm et 3000 ppm.

3.  Procédé d'élaboration selon la revendication 1, du genre où l'on assure, préalablement à ladite élaboration, une préoxydation du support de nitrure d'aluminium sous atmosphère oxydante, notamment sous air ou sous un mélange d'azote, d'hydrogène et de vapeur d'eau, à une température comprise entre 1200°C et 1500°C pendant une durée de l'ordre de l'heure, caractérisé en ce que pour la phase de cuisson, on limite l'atmosphère d'élimination des résines polymères à une teneur en oxygène inférieure à 250 ppm.

**Patentansprüche**

1. Verfahren zur Herstellung elektrischer Verbindungsmittel, insbesondere Verbindungssubstrate für Hybridschaltungen, bei dem nach dem Aufbringen einer Rohtintenschicht auf der Basis von Nichtedelmetallen auf einen Träger mit hoher Wärmedissipation, z.B. Aluminiumnitrid, zunächst eine Trocknung dieser Tinte bei einer Temperatur zwischen 100°C und 150°C und dann ein Einbrennvorgang durchgeführt werden, der

   a) einen eine Phase zur Entfernung von in der Tinte enthaltenen polymeren Harzen einschließenden Temperaturanstieg,
   b) eine Sinterstufe bei einer Temperatur zwischen 600°C und 1000°C, und
   c) eine verzögerte Abkühlung

   umfaßt, wobei die Atmosphäre der Phase zur Entfernung der polymeren Harze einen Sauerstoffgehalt aufweist, der bis zu mehreren hundert ppm betragen kann, während die Sauerstoffgehalte der Sinter-Atmo-sphäre bei der Temperatur zwischen 600°C und 1000°C und der Abkühl-Atmosphäre kleiner als 10 ppm bleiben, dadurch gekennzeichnet, daß die Atmosphäre der Phase zur Entfernung der polymeren Harze einen Sauerstoffgehalt zwischen 100 ppm und 5000 ppm aufweist.

2. Verfahren nach Anspruch 1, dadurch gekennzeichnet, daß die Atmosphäre der Phase zur Entfernung der polymeren Harze einen Sauerstoffgehalt zwischen 250 ppm und 3000 ppm aufweist.

3. Verfahren nach Anspruch 1, bei dem der Herstellung vorangehend eine Voroxydation des Aluminiumnitrid-Trägers in einer oxydierenden Atmosphäre, insbesondere in Luft oder einem Gemisch aus Stickstoff, Wasserstoff und Wasserdampf, bei einer Temperatur zwischen 1200°C und 1500°C und während einer Dauer von etwa einer Stunde durchgeführt wird, dadurch gekennzeichnet, daß die Atmosphäre zur Entfernung der polymeren Harze für die Einbrennphase auf einen Sauerstoffgehalt von weniger als 250 ppm beschränkt wird.

**Claims**

1. Method for producing electrical connection means, in particular interconnecting substrates for hybrid circuits, according to which, after deposition of a layer of untreated ink based on non-noble metals on a high thermal dissipation support of the aluminium nitride type, a preliminary drying of this ink is carried out at a temperature of between 100°C and 150°C, and then baking is carried out comprising:

   a) a rise in temperature incorporating a phase of elimination of the polymer resins contained in the untreated ink,
   b) a sintering stage at a temperature of between 600°C and 1000°C, and
   c) a timed cooling,

   the atmosphere of the polymer resin elimination phase having an oxygen content which may be as much as several hundred ppm, whilst the oxygen contents of the sintering atmosphere at the temperature between 600° and 1000°C and of the cooling atmosphere remain below 10 ppm, characterised in that the atmosphere of the polymer resin elimination phase has an oxygen content of between 100 ppm and 5000 ppm.

2. Production method according to Claim 1, characterised in that the atmosphere of the polymer resin elimination phase has an oxygen content of between 250 ppm and 3000 ppm.

3. Production method according to Claim 1, of the type in which, prior to the said production, the aluminium nitride support is pre-oxidised in an oxidising atmosphere, notably in air or in a mixture of nitrogen, hydrogen and steam, at a temperature of between 1200°C and 1500°C for a period of around 1 hour, characterised in that, for the baking phase, the polymer resin elimination atmosphere is limited to an oxygen content of below 250 ppm.